Europäisches Patentamt

European Patent Office

Office européen des brevets

(11) Publication number: **0 425 148 A2**

# EUROPEAN PATENT APPLICATION

(21) Application number: 90311206.8

(22) Date of filing: 12.10.90

(51) Int. Cl.⁵: **H01L 21/48**, H05K 3/46

The title of the invention has been amended (Guidelines for Examination in the EPO, A-III, 7.3).

(30) Priority: 23.10.89 US 425620

(43) Date of publication of application:
**02.05.91 Bulletin 91/18**

(84) Designated Contracting States:
**DE FR GB NL**

(71) Applicant: AMERICAN TELEPHONE AND
TELEGRAPH COMPANY
550 Madison Avenue
New York, NY 10022(US)

(72) Inventor: O'Brien, Mark Steven
1332 No. 2 Chew Street
Allentown, Pennsylvania 18102(US)

(74) Representative: Johnston, Kenneth Graham et al
AT&T (UK) LTD. AT&T Intellectual Property
Division 5 Mornington Road
Woodford Green Essex, IG8 OTU(GB)

(54) **Method of forming multilayer thick film circuits.**

(57) Disclosed is a method of forming multilayer thick film circuits. Each layer is formed from a ceramic green sheet (10-13) with appropriate conductive patterns (14) on the surface. The sheets are laminated by means of an isostatic pressure process which uses a gas as the pressing medium. The layers are subsequently co-fired to form the final article.

EP 0 425 148 A2

## GASEOUS ISOSTATIC LAMINATION PROCESS

### Background of the Invention

This invention relates to fabricating thick film circuits.

With the increasing complexity of silicon integrated circuit chips, a need has arisen for thick film hybrid circuits of greater complexity and finer lines. In order to meet this need, a technology has developed employing low temperature co-fired ceramic processing. This technology involves fabricating multilayer circuits by laminating separate layers of unfired (green) ceramic sheets, each with its own pattern of conductors, resistors, and capacitors (see, e.g., Bheduar, et al "Low Temperature Co-Fired Ceramic Tape System - An Overview," First International SAMPE Electronics Conference, June 23-25,1987 at pp. 720-734.)

At present, lamination of the separate sheets is done either by a uniaxial or an isostatic pressing process. The uniaxial process, while effective, has the disadvantage of requiring inserts and confining dies in most cases. The present isostatic process, which is also effective, uses a liquid pressing medium such as water, and this requires placing the sheets in a bag to protect the components during lamination. In addition to the fact that bagging of parts slows down the process, the bags can rupture or leak under pressure resulting in damage to the components.

It is therefore an object of the invention to provide an alternative method of laminating ceramic sheets for multilayer thick film circuit fabrication.

### Summary of the Invention

This and other objects are achieved in accordance with the invention which is a method of fabricating multilayer thick film circuits. A plurality of ceramic sheets is provided, each with conductive patterns on at least one major surface. The sheets are stacked within an enclosure and a gas is introduced therein to provide sufficient pressure isostatically to said sheets to cause adherence between the sheets. Subsequently, the resulting structure is heated to sinter together the plurality of sheets.

### Brief Description of the Drawing

These and other features of the invention are delineated in detail in the following description. In the drawings:

FIG. 1 is an exploded perspective view of a stack of sheets for fabricating a circuit in accordance with an embodiment of the invention.

FIG. 2 is a side view of a portion of an apparatus for laminating said sheets which can be utilized in accordance with the same embodiment, and

FIG. 3 is a schematic view of a further portion of an apparatus for laminating said sheets in accordance with the same embodiment.

It will be appreciated that for purposes of illustration these figures are not necessarily drawn to scale.

### Detailed Description

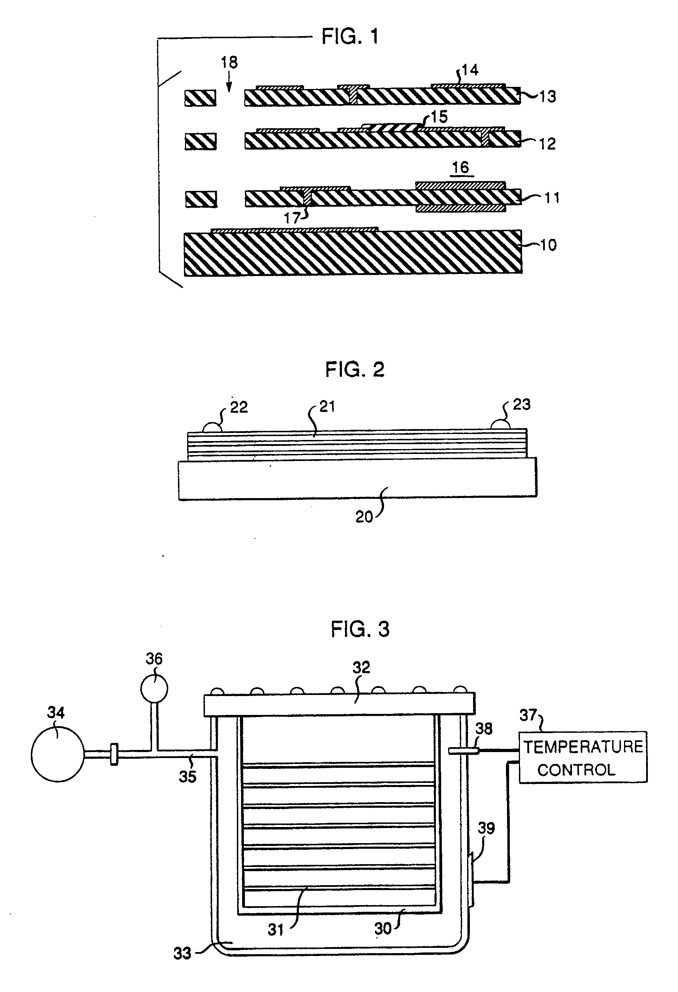

FIG. 1 shows, for illustrative purposes, a simple multilayer thick film circuit which could be manufactured in accordance with the invention. The circuit includes several layers of ceramic sheets, 10-13, which are in an unfired or "green" state. The sheets typically vary in thickness from .1 to .3 mm. Each sheet has two opposite major surfaces with conductive patterns formed on one or more of the surfaces. The patterns includes conductors (eg, 14), resistors (15), and capacitors (16). Also included are via holes (eg, 17) formed through the sheets and filled with conductive material to provide interconnection between the components on the various levels, and a cavity, 18, through sheets, 11-13, for mounting of a semiconductor chip (not shown). The patterns are formed by standard thick film techniques such as screen printing using standard materials. For example, the conductors may be Au, the resistor material Ruthenium based, and the capacitor formed from two conductors on either side of a ceramic sheet as shown. The via holes may be filled by Au. While the patterns are printed on the sheets, the sheets remain unfired until later in the processing as described below.

The plurality of sheets are stacked for the purpose of lamination on a plate such as illustrated in FIG. 2. The plate comprises a base, 20, typically made of Aluminum. The sheets, eg, 21, are aligned on the plate by means of alignment pins, 22 and 23, which extend from the base through holes formed in the sheets. After stacking, several of such plates may be placed in a rack such as that shown as 30 in FIG. 3. The rack includes several shelves, eg, 31, upon which the sheets (not shown) may be mounted in primarily a horizontal orientation. The shelves are coupled by a frame to a cap, 32, which provides a vacuum-tight seal over chamber, 33, within which the rack is situated. A source, 34, of gas is coupled to chamber, 33, by inlet, 35. Also coupled to the inlet is a pressure gauge, 36, for monitoring the pressure of the incoming gas. A standard temperature control apparatus, 37, is also coupled to the chamber through a high presure thermocouple, 38, and heat tape, a portion of which is shown as 39, which is typically a resistor material formed over most of the surface of the chamber.

The particular apparatus employed was a commercially available isostatic pressure equipment sold by Pressure Products Incorporated under the designation AOH.

In a particular example, the sheets were first prelaminated in a standard uniaxial press such as that sold by Hull under the designation 359-Fin order to remove trapped gas between the sheets. This pre-lamination was effected at a low presure (less than 70 Kg/cm$^2$) with the sheets heated to a temperature of approximately 70 degrees C for a time of 1 minute. The sheets were then loaded into the pressure chamber, 33, and air from the gas source, 34, was introduced therein to create a pressure of approximately 210 Kg/cm$^2$. Preferably, the pressure should be within the range 150 to 250 Kg/cm$^2$. The rack was kept at a temperature of approximately 70 degrees C, although a range of 50 degrees C to 110 degrees C could be utilized. The isostatic lamination was carried on for approximately 10 minutes although times within the range 5 to 15 minutes are generally useful.

Subsequent to the lamination process, the resulting multilayer parts were removed from the pressing apparatus and placed in a standard furnace for firing. A standard burnout of organic material was effected at a temperature of approximately 350 degrees C for about 1 hour. This was followed by sintering at a temperature of approximately 850 degrees C for about 15 minutes. For most ceramic sheets, a burnout will be performed at 250 to 500 degrees C for 1/2 to 4 hours, and a sintering at 750 to 950 degrees C for 5 minutes to 2 hours. While the lamination process results in a bonding of the various sheets, the firing process fuses the ceramic layers together to form a homogeneous ceramic with the various conductors, resistors, and capacitors embedded therein.

It was discovered that the gaseous lamination technique of the present invention results in multilayers with good adherence and apparently no air trapped between the layers. Proper registration was also maintained between the layers during the lamination process in spite of the gas flow. As in the liquid isostatic process, no inserts were needed for defining cavities within the layers, nor was a confining die needed to prevent parts from being pressed out of the stack. However, unlike the liquid process, the present process was done without bagging of the parts.

Various modifications of the invention will become apparent to those skilled in the art. For example, a non-reactive gas such as nitrogen may be employed as the gas medium instead of air. Further, although the process is preferably carried out without a bag, it might be desirable in certain cases to bag the sheets prior to lamination. The bag, however, can be much thinner than that generally needed for liquid pressing medium (.02 mm thickness), and consequently provide better conformance to edges and cavity walls. In addition, the pre-lamination step may be unnecessary if the chamber, 33, is first evacuated prior to introduction therein of the gas from source, 34. All such variations which basically rely on the teachings through which the invention has advanced the art are properly considered within the scope of the invention.

## Claims

1. A method of fabricating multilayer thick film circuits comprising the steps of:
providing a plurality of ceramic green sheets (10-13) each with conductive patterns (14) on at least one major surface thereof; and
CHARACTERIZED in the steps of
stacking said sheets within a chamber (33) and introducing therein a gas which provides sufficient pressure isostatically to said sheets to cause adherence between the sheets; and
subsequently heating the resulting structure to sinter together the plurality of sheets.

2. The method according to claim 1 wherein the gas is selected from the group consisting of air and nitrogen.

3. The method according to claim 1 wherein the pressure is within the range 150 to 250 Kg/cm$^2$.

4. The method according to claim 1 wherein, prior to applying the pressure isostatically, the stack of sheets is subjected to a uniaxial pressure.

5. The method according to claim 4 wherein the uniaxial pressure is within the range 25 to 75 Kg/cm$^2$.

6. The method according to claim 1 wherein the sheets are stacked within the chamber without any compliant bag surrounding the sheets.

7. The method according to claim 3 wherein the stacks are held at a temperature within the range 50 degrees C to 110 degrees C and pressure is applied for a time within the range 5 to 15 minutes.

FIG. 1

FIG. 2

FIG. 3

TEMPERATURE CONTROL